# EUROPÄISCHE PATENTSCHRIFT

(11) **EP 0 947 128 B1**
(45) Veröffentlichungstag und Bekanntmachung des Hinweises auf die Patenterteilung: **27.09.2000**
(21) Anmeldenummer: 97953892.3
(22) Anmeldetag: 19.12.1997
(51) Int. Cl.: H05K 7/20, H01L 23/34

(54) **BAUELEMENTTRÄGER MIT LUFT-UMWÄLZKÜHLUNG DER ELEKTRISCHEN BAUELEMENTE**
COMPONENT HOLDER WITH CIRCULATING AIR COOLING OF ELECTRICAL COMPONENTS
SUPPORT DE COMPOSANTS A REFROIDISSEMENT PAR CIRCULATION D'AIR DES COMPOSANTS ELECTRIQUES

(30) Priorität: 20.12.1996 DE 19653523
(43) Veröffentlichungstag der Anmeldung: 06.10.1999
(73) Patentinhaber: MAGNET-MOTOR GESELLSCHAFT FÜR MAGNETMOTORISCHE TECHNIK MBH, 82319 Starnberg (DE)
(72) Erfinder: WICKELMAIER, Peter, D-81671 München (DE); ÖREY, Suavi, D-82319 Söcking (DE); EHRHART, Peter, D-81375 München (DE)
(74) Vertreter: Klunker . Schmitt-Nilson . Hirsch
(86) Internationale Anmeldenummer: EP9707207
(87) Internationale Veröffentlichungsnummer: WO9828961

(56) Entgegenhaltungen:
- EP-A- 0 053 967
- US-A- 4 246 597
- US-A- 4 536 824

## Beschreibung

Die Erfindung betrifft einen Bauelementträger mit daran angebrachten elektrischen oder elektronischen Bauelementen, aufweisend mindestens einen Kanal für Kühlflüssigkeit.

Derartige Bauelementträger werden als Träger für Bauteile leistungselektronischer Geräte verwendet, wobei die in dem Kanal strömende Kühlflüssigkeit der Kühlung der Leistungsbauteile dient. Sie werden entweder als Einschubelemente ohne Gehäuse oder fest in ein Gehäuse eingebaut auf dem Markt angeboten. Durch die stetig zunehmende Packungsdichte leistungselektronischer Geräte wird die Kühlung der Leistungsbauteile ein immer größeres Problem. Außerdem werden Bauelementträger mit den elektrischen Bauelementen häufig in geschlossenen Systemen verwendet, beispielsweise um Anforderungen an die EMV-Dichtheit und IP-Anforderungen zu erfüllen. In der verbesserten Abführung der entstehenden thermischen Verlustleistung liegt deshalb ein wesentliches Potential, die Packungsdichte und Kompaktheit leistungselektronischer Geräte weiter zu erhöhen.

Es ist deshalb Aufgabe der vorliegenden Erfindung, einen Bauelementträger bereitzustellen, bei dem die Abfuhr der thermischen Verlustleistung elektronischer Bauelemente verbessert ist.

Das wird erfindungsgemäß dadurch erreicht, daß der Bauelementträger einen Luftkühlkörper aufweist und daß dem Bauelementträger ein Lüfter zugeordnet ist, mit dem ein Umwälz-Luftstrom zur Luftkühlung mindestens eines Teils der Bauelemente und zur Luftrückkühlung an dem Luftkühlkörper erzeugbar ist. Durch den Umwälz-Luftstrom kann im Betrieb eine optimale Kühlung der Bauelemente erfolgen, die fast ausschließlich auf die Luftkühlung angewiesen sind, z. B. eine Vielzahl von Kondensatoren oder eine interne Verkabelung des leistungselektronischen Geräts. Darüberhinaus kann auch bei solchen Bauelementen, die durch ihre Bauart bedingt auf von der Flüssigkeitskühlung gekühlten Montagesockeln montiert sind, eine zusätzliche Luftkühlung über die Gehäusewände der Bauelemente erfolgen. Damit bietet die Erfindung die Möglichkeit, die Flüssigkeitskühlung über die Montagesockel der Bauelemente mit einer zusätzlichen Luftkühlung zu kombinieren. Die Luftrückkühlung kann an einem Luftkühlkörper erfolgen, der von der Kühlflüssigkeit der Flüssigkeitskühlung gekühlt wird.

Vorzugsweise ist der Bauelementträger mindestens aus einer Trägerplatte mit den Bauelementen und dem Luftkühlkörper zusammengesetzt. Dabei ist es besonders bevorzugt, wenn die Trägerplatte und der Luftkühlkörper flächig miteinander verbunden sind und den mindestens einen Kanal zwischen sich einschließend. Das führt zu einem besonders einfachen Aufbau und damit zu einer Arbeitserleichterung bei der Herstellung des Bauelementträgers. Der Kanal kann einfach aus der Oberfläche eines der beiden plattenartigen Elemente herausgearbeitet werden, bevor beide miteinander verbunden werden. Alternativ ist auch eine einstückige Ausbildung des Bauelementträgers vorstellbar. Beispielsweise kann der Kanal in einem einstückigen Bauelementträger eingegossen sein.

Weiterhin ist es bevorzugt, wenn der mindestens eine Kanal mit einer Eintrittsöffnung und einer Austrittsöffnung so vorgesehen ist, daß sich beide Öffnungen an oder bei einer Stirnfläche des Bauelementträgers befinden. Bei dieser Anordnung ist eine besonders einfache Anschlußmöglichkeit für die Zuführung der Kühlflüssigkeit und für die Abführung der Kühlflüssigkeit gegeben, und beide können an einer Seite des Bauelementträgers zusammengefaßt angeordnet sein. Alternativ kann es auch von Vorteil sein, mindestens einen Kanal mit einer Eintrittsöffnung und einer Austrittsöffnung so vorzusehen, daß sich die Öffnungen an oder bei entgegengesetzten Stirnflächen des Bauelementträgers befinden.

Als besonders günstig hat sich herausgestellt, den Luftkühlkörper mit Kühlrippen oder Kühllamellen auszubilden. Damit ist eine besonders große Wärmeaustauschfläche gegeben, was entsprechend zu einem besonders großen Wärmeaustausch im Betrieb beiträgt. Der Wärmeaustausch kann zudem durch die Verwendung eines Materials mit guter Wärmeleitfähigkeit für den Luftkühlkörper begünstigt sein. Die Verwendung eines Materials mit guter Wärmeleitfähigkeit bietet sich auch für die Trägerplatte an, um eine gute Kühlung der Montagesockel zu ermöglichen.

Es hat sich auch als besonders bevorzugt herausgestellt, den Lüfter so anzuordnen, daß betriebsmäßig der durch den Betrieb des Lüfters erzeugte Luftstrom an einer Seite des Bauelementträgers von dem Lüfter wegführt und an der anderen Seite des Bauelementträgers zu dem Lüfter hinführt. So kann die Umwälzung in einem geschlossenen Kreis erfolgen. Der Bauelementträger selbst dient als Trennwand zwischen der dem Lüfter zuströmenden und von dem Lüfter wegströmenden Luft. Der besondere Vorteil zeigt sich dann, wenn die Bauelemente alle auf einer Seite des Bauelementträgers angeordnet sind und der Luftkühlkörper auf der anderen Seite angeordnet ist. Die umströmende Luft kühlt auf dem ersten Teil ihres Strömungswegs die Bauelemente und wird auf der anderen Seite beim Zurücksströmen von dem Luftkühlkörper rückgekühlt. Dabei kann es durchaus auch vorteilhaft sein, auf der Seite, an der die Bauelemente angeordnet sind, ebenfalls einen Luftkühlkörper beispielsweise in der Nähe eines besonders viel Verlustleistung abgebenden Bauelements vorzusehen. Es ist auch vorstellbar, Luftkühlkörper und Bauelemente auf beiden Seiten des Bauelementträgers gemeinsam anzuordnen.

Es kann auch bevorzugt sein, daß in dem Bauelementträger mindestens eine Durchströmöffnung vorgesehen ist, durch die mindestens ein Teil des Luftstroms von der einen Seite zu der anderen Seite strömen kann. Alternativ zu oder zusätzlich zu der Zirkulation um den gesamten Bauelementträger herum kann dadurch eine Zirkulation um einen Teil des Bauelementträgers ausgebildet sein. Das ist insbesondere dann bevorzugt, wenn eine Durchströmöffnung des Bauelementträgers bei einem Bauelement so angeordnet ist, daß der dadurch hindurchströmende Teil des Luftstroms dieses gezielt kühlen kann. Je nach der speziellen räumlichen Anordnung der Durchströmöffnung durch den Bauelementträger und des Bauelements an dem Bauelementträger kann dem Bauelement ganz gezielt ein Luftstrom einer bestimmten Temperatur zugeführt werden und damit eine besonders optimale Verlustleistungsabfuhr erreicht werden. Dabei können Querschnitt und Anzahl der Durchströmöffnungen auf die an den Gehäuseoberflächen der Bauelemente zu erzielenden Kühlwirkungen abgestimmt sein. Die Position der Durchströmöffnung ist einer der die Temperatur des Teilluftstroms oder des gesamten Luftstroms bestimmenden Faktoren. Bei der Festletung der geometrischen Lage der Durchströmöffnungen durch den Bauelementträger wird bevorzugt ein Optimum bezüglich Temperatur, Volumendurchsatz und Druckabfall der Kühlluft eingestellt.

Vorzugsweise ist an dem Bauelementräger ein Leitelement zum gezielten Leiten eines Teils des Lufstroms vorgesehen. Dadurch kann der Luftstrom beispielsweise gezielt auf ein Bauelement hin oder um ein Bauelement herum geleitet werden. Ein solches Leitelement kann ein einfaches plattenartiges Leitelement, beispielsweise in der Form eines Leitblechs, sein. Es kann sich aber auch insbesondere um ein düsenartiges Leitelement handeln, welches einer Durchströmöffnung zugeordnet ist. Ein solches Leitelement kann die durch die Durchströmöffnung hindurchströmende Luft nicht nur gezielt auf ein Bauelement hinleiten, sondern kann darüberhinaus auch die Luftströmung lokal beschleunigen und damit eine örtlich besonders hohe Kühlleistung erbringen. Unter anderem aus fertigungstechnischen Gründen ist es besonders bevorzugt, ein aufsteckbares, düsenartiges Leitelement vorzusehen, das beispielsweise einfach auf die Durchströmöffnung aufgesteckt sein kann. Allgemein ist es besonders bevorzugt, die geometrische Montagelage der Bauelemente auf dem Bauelementträger, die Führung des Luftstroms in einer Zirkulation um den gesamten Bauelementträger und/oder einen Teil des Bauelementträgers, die Anordnung von Leitelementen, Durchströmöffnung, etc. auf die abzuführende Verlustleistung und die zulässige Temperaturerhöhung hin abzustimmen und entsprechend auszulegen. Dabei ist auch die von dem Bauelementträger über den Montagesockel der Bauelemente aufgenommene Verlustleistung mit den zugehörigen Temperaturbedingungen in die entsprechenden Überlegungen mit einzubeziehen. Es kann bevorzugt sein, über den Montagesockel gekühlte Bauelemente, die eine hohe Verlustleistung haben und auf niedrige Betriebstemperaturen angewiesen sind, in der Nähe des Kühlwassereintritts vorzusehen und solche, die zwar auch eine hohe Verlustleistung haben aber auch mit höheren Betriebstemperaturen zurechtkommen, in der Nähe des Kühlwasseraustritts vorzusehen.

Ein weiterer bedeutsamer Faktor für die Auslegung ist der Durchströmquerschnitt zwischen der Außengrenze des Systems im Betrieb und dem Bauelementträger. Dieser beeinflußt wesentlich die Geschwindigkeit des Luftstroms am Luftkühlkörper und die Geschwindigkeit und die Verteilung des Luftstroms bei den Bauelementen. Er läßt sich so dimensionieren, daß sich ein Optimum von Luftvolumendurchsatz und -geschwindigkeit an den Bauelementen einerseits und Rückkühlung am Luftkühlkörper andererseits einstellt.

Vorzugsweise ist der Lüfter an einer der Stirnseiten des Bauelementträgers angeordnet. Das gewährleistet eine besonders einfache Anbringung und eine besonders einfache Zugangsmöglichkeit und führt darüberhinaus zu besonders günstigen Strömungsverläufen. Bei dem Lüfter kann es sich insbesondere um einen Querstromlüfter oder aber auch bevorzugt um einen Radiallüfter handeln.

Gegenstand der Erfindung ist weiterhin ein elektronisches Gerät aufweisend einen der vorangehend beschriebenen Bauelementträger, der in einem Gehäuse so angeordnet ist, daß der Luftstrom im Betrieb zwischen der einen Seite des Bauelementträgers und der Gehäusewand und zwischen der anderen Seite des Bauelementträgers und der Gehäusewand geführt ist. Vorzugsweise sind bei dem elektronischen Gerät vorzugsweise zwei Bauelementträger mit einem gemeinsamen Lüfter in einem Gehäuse vorgesehen, wobei je die Seiten mit den Bauelementen oder die Seiten mit den Luftkühlkörpern einander entgegengesetzt angeordnet sind und zwischen sich einen Strömungskanal für den Luftstrom bilden. Der Luftstrom strömt so einen Teil des Strömungsweges in einem gemeinsamen Strömungskanal und kühlt dort entweder die Bauelemente der beiden entgegengesetzt angeordneten Bauelementträger oder wird dort durch die einander entgegengesetzt angeordneten Luftkühlkörper gekühlt und teilt sich dann auf dem zweiten Teil seines Strömungsweges auf, um an den entsprechenden voneinander wegragenden Seiten der Bauelementträger zurückzuströmen. Es kann auch die umgekehrte Strömungsrichtung bevorzugt sein. Der Vorteil dieser Anordnung liegt darin, daß für je zwei Bauelementträger nur ein gemeinsamer Lüfter vorgesehen ist. Das ermöglicht eine noch kompaktere Anordnung.

Die Erfindung wird nachfolgend anhand von zeichnerisch dargestellten Ausführungsbeispielen noch näher erläutert. Es zeigt:
- Fig. 1: einen Längsschnitt durch einen erfindungsgemäßen Bauelementträger;
- Fig. 2: einen Querschnitt durch eine erfindungsgemäßen Bauelementträger; und
- Fig. 3: einen Längsschnitt ähnlich Fig. 1, der eine besondere Art der Anordnung von zwei Bauelementträgern zeigt.

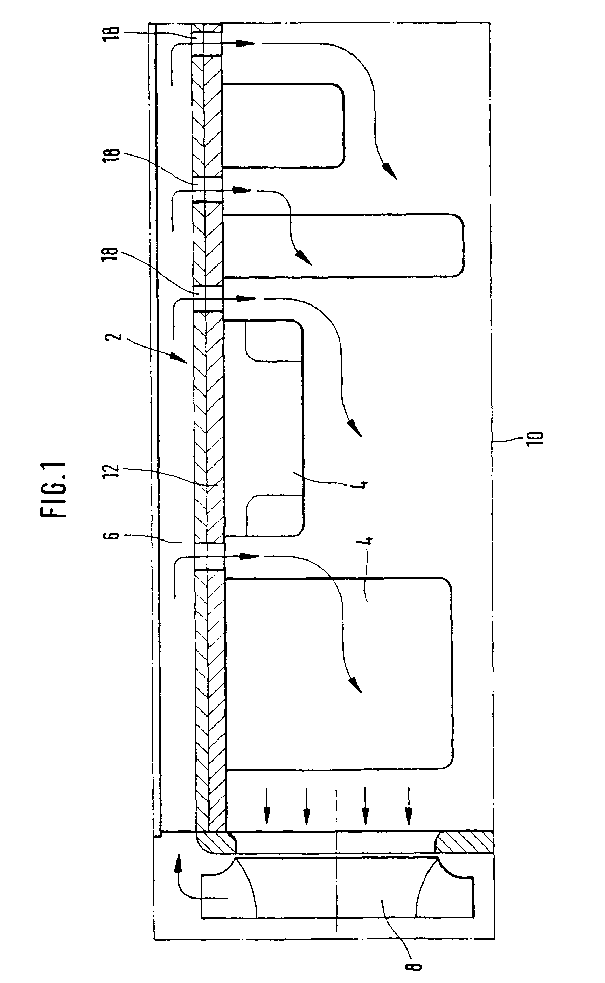

Fig. 1 zeigt einen Bauelementträger 2 mit daran angebrachten elektrischen Bauelementen 4, einem Luftkühlkörper 6 und einem Lüfter 8. Der Bauelementträger 2 ist in einem Gehäuse 10 angeordnet. Er ist aus einer Trägerplatte 12, auf der die Bauelemente 4 montiert sind, und einem Luftkühlkörper 6 zusammengesetzt. Bei der Trägerplatte 12 und dem Luftkühlkörper 6 handelt es sich um im wesentlichen plattenförmige Elemente, die einen Kanal 14 zwischen sich einschließend flächig miteinander verbunden sind.

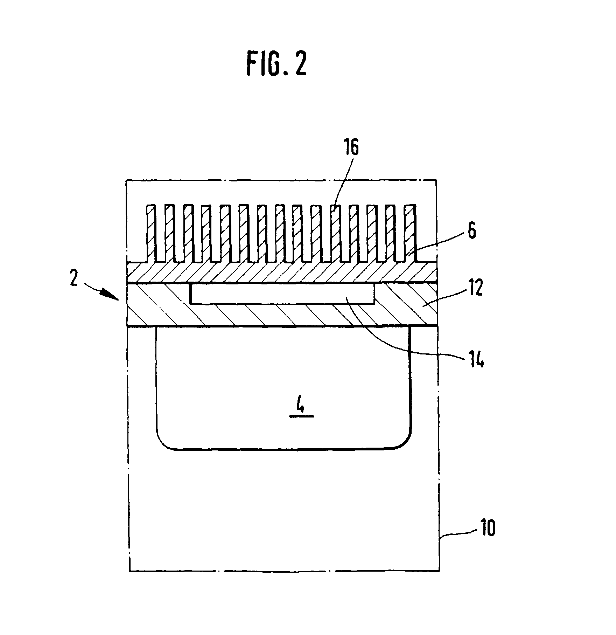

Wie aus Fig. 2 ersichtlich, handelt es sich bei dem Kanal um ein relativ flaches Rechteck im Querschnitt und er erstreckt sich im wesentlichen über die ganze Breite des Bauelementträgers 2. Ein derartiger Kanal 14 kann vor dem flächigen miteinander Verbinden des Platinenelements 12 und des Luftkühlkörpers 6 relativ einfach aus einem der beiden plattenförmigen Elemente herausgearbeitet werden, z. B. durch Fräsen. Die Eintrittsöffnung und die Austrittsöffnung für Kühlflüssigkeit befindet sich bei der gezeigten Ausführung an entgegengesetzten Stirnseiten des Bauelementträgers 2 und sind in den Zeichnungen nicht dargestellt. Die durch den Kanal 14 fließende Kühlflüssigkeit dient einerseits dazu, die an dem Bauelementträger befestigten Bauelemente über ihren Montagesockelbereich zu kühlen, und weiterhin dazu, die durch den Lüfter 8 umgewälzte Luft an dem Luftkühlkörper 6 rückzukühlen. Das führt bei relativ geringem Aufwand zu einer besonders hohen Kühlwirkung.

Der Luftkühlkörper 6 besteht bevorzugt aus einem besonders gut wärmeleitenden Material und ist zur Erhöhung der Wärmetauschfläche mit Kühlrippen oder Kühllamellen 16 versehen, um einen möglichst hohen Wärmeübertrag zwischen dem Luftstrom und der Kühlflüssigkeit zu erzielen.

Der Lüfter 8, bei dem es sich zur Erzielung einer möglichst großen Druckdifferenz um einen Radiallüfter handelt, ist an einer der Stirnseiten des Bauelementträgers 2 angeordnet, so daß der von ihm erzeugte Luftstrom, wie in Fig. 1 durch Pfeile dargestellt, an der Oberseite des Bauelementträgers 2 von ihm wegführt und an der Unterseite des Bauelementträgers zu dein Lüfter 8 hinführt. Dabei nimmt der Luftstrom beim Vorbeiströmen an den elektronischen Leistungsbauelementen 4 in Form von Wärme frei werdende Verlustleistung auf und gibt sie bei dem Luftkühlkörper 6 auf der Oberseite an die Kühlflüssigkeit ab. Der Luftstrom durchströmt dabei einen Kanal, der sowohl auf der Oberseite als auch auf der Unterseite im wesentlichen von der Gehäusewand 10 und dem Bauelementträger 2 gebildet ist. Betrachtet man Fig. 2, so erkennt man, daß die Luftkanäle zur Seite hin ebenfalls von Wänden des Gehäuses 10 begrenzt werden und der Luftkanal der Oberseite von dem der Unterseite durch den Bauelementträger 2 getrennt ist, der jeweils bis an das Gehäuse 10 ragt.

Durch den Bauelementträger 2 sind mehrere Durchströmöffnungen 18 vorgesehen, durch die je ein Teil des luftstroms von der Oberseite zur Unterseite strömen kann. In Fig. 1 erkennt man, daß die Durchströmöffnungen 18 so angeordnet sind, daß sie einzelnen Bauelementen 4 zugeordnet sind, so daß diese im wesentlichen von dem Teil des Luftstroms gezielt gekühlt werden, der durch die entsprechende Durchströmöffnung 18 hindurchströmt. Der Kanal 14 für die Kühlflüssigkeit ist zu den Durchströmöffnungen 18 hin natürlich jeweils abgeschlossen und ist deshalb in dem Bereich der Durchströmöffnungen 18 schmaler als in dem in Fig. 2 gezeigten Bereich.

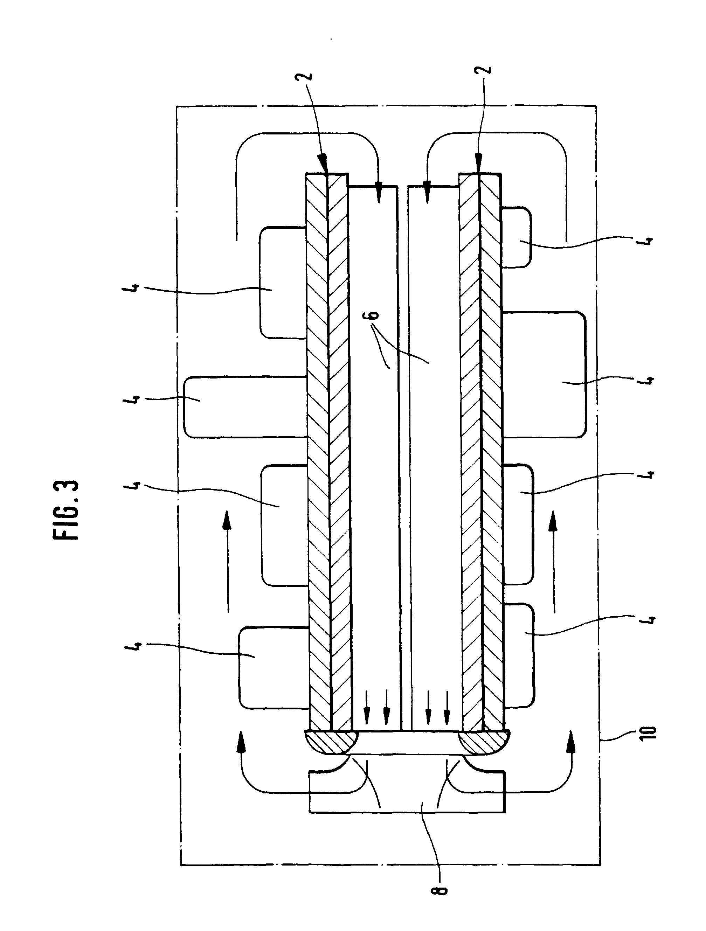

In der Darstellung von Fig. 3 ist die Anordnung von zwei Bauelementträgern 2 "Rücken an Rücken" mit einem Lüfter 8 in einem Gehäuse 10 gezeigt. Man erkennt, wie die Luftkühlkörper 6 der beiden Bauelementträger 2 gegeneinander ausgerichtet angeordnet sind und wie die Seiten der Bauelementträger 2, auf denen die Bauelemente 4 montiert sind, voneinander wegweisend angeordnet sind. Dadurch ist zwischen den Bauelementträgern 2 ein Kanal gebildet, der von zwei Seiten von Luftkühlkörpern 6 sandwichartig eingeschlossen ist. Das führt dazu, daß im Verhältnis zu der in den Figuren 1 und 2 gezeigten Anordnung für je zwei Bauelementträger 2 ein Lüfter 8 eingespart sein kann. Es kann auch zu einer Verbesserung der Kühlleistung demgegenüber führen. Das ermöglicht demgegenüber eine noch kompaktere Bauweise. Verglichen mit der vorangehend beschriebenen Ausführungsform ist bei der Ausführungsform von Fig. 3 die Zirkulationsrichtung umgedreht, d. h. der Luftstrom führt von den Luftkühlkörpern 6 zu dem Lüfter 8 hin und von diesem weg zu den Bauelementen 4. Zudem ist zu jedem einzelnen Bauelementträger 2 nur ein geschlossener Zirkulationskreis gezeigt, so daß die Luft um die Stirnseiten des Bauelementträgers 2 herumströmt und dazwischen keine Durchströmöffnungen vorgesehen sind.

## Patentansprüche

1. Bauelementträger (2) mit daran angebrachten elektrischen Bauelementen (4), aufweisend mindestens einen Kanal (14) für Kühlflüssigkeit,
**dadurch gekennzeichnet,**
daß der Bauelementträger (2) einen Luftkühlkörper (6) aufweist, und daß dem Bauelementträger (2) ein Lüfter (8) zugeordnet ist, mit dem ein Umwälz-Luftstrom zur Luftkühlung mindestens eines Teils der Bauelemente (4) und zur Luftrückkühlung an dem Luftkühlkörper (6) erzeugbar ist.

2. Bauelementträger (2) nach Anspruch 1,
**dadurch gekennzeichnet,**
daß er mindestens aus einer Trägerplatte (12) mit den Bauelementen (4) und dem Luftkühlkörper (6) zusammengesetzt ist.

3. Bauelementträger (2) nach Anspruch 2,
**dadurch gekennzeichnet,**
daß die Trägerplatte (12) und der Luftkühlkörper (6) flächig miteinander verbunden sind und den mindestens einen Kanal (14) zwischen sich einschließen.

4. Bauelementträger (2) nach einem der Ansprüche 1 bis 3,
**dadurch gekennzeichnet,**
daß der mindestens eine Kanal (14) mit einer Eintrittsöffnung und einer Austrittsöffnung so vorgesehen ist, daß sich beide Öffnungen an oder bei einer Stirnseite des Bauelementträgers (2) befinden.

5. Bauelementträger (2) nach einem der Ansprüche 1 bis 3,
**dadurch gekennzeichnet,**
daß der mindestens eine Kanal (14) mit einer Eintrittsöffnung und einer Austrittsöffnung so vorgesehen ist, daß sich die Öffnungen an oder bei entgegengesetzten Stirnseiten des Bauelementträgers (2) befinden.

6. Bauelementträger (2) nach einem der vorhergenden Ansprüche,
**dadurch gekennzeichnet,**
daß der Luftkühlkörper (6) Kühlrippen oder Kühllamellen (16) aufweist.

7. Bauelementträger (2) nach einem der vorhergehenden Ansprüche,
**dadurch gekennzeichnet,**
daß der Lüfter (8) so angeordnet ist, daß betriebsmäßig der durch den Betrieb des Lüfters (8) erzeugte Luftstrom an einer Seite des Bauelementträgers (2) von dem Lüfter (8) wegführt und an der anderen Seite des Bauelementträgers (2) zu dem Lüfter (8) hinführt.

8. Bauelementträger (2) nach einem der vorhergehenden Ansprüche,
**dadurch gekennzeichnet,**
daß darin mindestens eine Durchströmöffnung (18) vorgesehen ist, durch die mindestens ein Teil des Luftstroms von der einen Seite zu der anderen Seite strömen kann.

9. Bauelementträger (2) nach Anspruch 8,
**dadurch gekennzeichnet,**
daß eine Durchströmöffnung (18) des Bauelementträgers (2) bei einem Bauelement (4) so angeordnet ist, daß der dadurch hindurchströmende Teil des Luftstroms dieses gezielt kühlen kann.

10. Bauelementträger (2) nach einem der vorhergehenden Ansprüche,
**dadurch gekennzeichnet,**
daß ein Leitelement zum gezielten Leiten eines Teils des Luftstroms vorgesehen ist.

11. Bauelementträger (2) nach Anspruch 10,
**dadurch gekennzeichnet,**
daß ein Leitelement zum gezielten Leiten eines Teils des Luftstroms zu einem Bauelement (4) vorgesehen ist.

12. Bauelementträger (2) nach Anspruch 10 oder 11,
**dadurch gekennzeichnet,**
daß ein düsenartiges Leitelement einer Durchströmöffnung (18) zugeordnet ist.

13. Bauelementträger (2) nach Anspruch 12,
**dadurch gekennzeichnet,**
daß ein aufsteckbares düsenartiges Leitelement vorgesehen ist.

14. Bauelementträger (2) nach einem der vorhergehenden Ansprüche,
**dadurch gekennzeichnet,**
daß der Lüfter (8) an einer der Stirnseiten des Bauelementträgers (2) angeordnet ist.

15. Bauelementträger (2) nach einem der vorhergehenden Ansprüche,
**dadurch gekennzeichnet,**
daß der Lüfter (8) ein Querstromlüfter ist.

16. Bauelementträger (2) nach einem der vorhergehenden Ansprüche,
**dadurch gekennzeichnet,**
daß der Lüfter (8) ein Radiallüfter ist.

17. Elektronisches Gerät aufweisend einen Bauelementträger (2) nach einem der Ansprüche 1 bis 16,
**dadurch gekennzeichnet,**
daß der Bauelementträger (2) in einem Gehäuse (10) so angeordnet ist, daß der Luftstrom im Betrieb zwischen der einen Seite des Bauelementträgers (2) und der Gehäusewand und zwischen der anderen Seite des Bauelementträgers (2) und der Gehäusewand geführt ist.

18. Elektronisches Gerät nach Anspruch 17,
**dadurch gekennzeichnet,**
daß zwei Bauelementträger (2) mit einem gemeinsamen Lüfter (8) in einem Gehäuse (10) vorgesehen sind, wobei je die Seiten mit den Bauelementen (2) oder die Seiten mit den Luftkühlkörpern (6) einander entgegengesetzt angeordnet sind und zwischen sich einen Strömungskanal für den Luftstrom bilden.

## Claims

1. A component carrier (2) with electric components (4) mounted thereon, having at least one channel (14) for cooling liquid, characterized in that the component carrier (2) has an air cooling body (6), and a fan (8) is associated with the component carrier (2) for producing a circulated air stream for air cooling at least part of the components (4) and for air recooling on the air cooling body (6).

2. The component carrier (2) of claim 1, characterized in that it is composed at least of a carrier plate (12) with the components (4) and the air cooling body (6).

3. The component carrier (2) of claim 2, characterized in that the carrier plate (12) and the air cooling body (6) are interconnected areally and enclose the at least one channel (14) between each other.

4. The component carrier (2) of any of claims 1 to 3, characterized in that the at least one channel (14) is provided with an inlet and outlet such that both openings are located on or near one face of the component carrier (2).

5. The component carrier (2) of any of claims 1 to 3, characterized in that the at least one channel (14) is provided with an inlet and outlet such that the openings are located on or near opposite faces of the component carrier (2).

6. The component carrier (2) of any of the above claims, characterized in that the air cooling body (6) has cooling ribs or cooling slats (16).

7. The component carrier (2) of any of the above claims, characterized in that the fan (8) is disposed such that in operation the air stream produced by operation of the fan (8) leads away from the fan (8) on one side of the component carrier (2) and leads to the fan (8) on the other side of the component carrier (2).

8. The component carrier (2) of any of the above claims, characterized in that at least one flow opening (18) is provided therein through which at least part of the air stream can flow from one side to the other side.

9. The component carrier (2) of claim 8, characterized in that a flow opening (18) of the component carrier (2) is disposed near a component (4) such that the partial air stream flowing therethrough can cool the component selectively.

10. The component carrier (2) of any of the above claims, characterized in that a guiding element is provided for selectively guiding part of the air stream.

11. The component carrier (2) of claim 10, characterized in that a guiding element is provided for selectively guiding part of the air stream to a component (4).

12. The component carrier (2) of claim 10 or 11, characterized in that a nozzle-like guiding element is associated with a flow opening (18).

13. The component carrier (2) of claim 12, characterized in that a slip-on nozzle-like guiding element is provided.

14. The component carrier (2) of any of the above claims, characterized in that the fan (8) is disposed on one of the faces of the component carrier (2).

15. The component carrier (2) of any of the above claims, characterized in that the fan (8) is a cross flow fan.

16. The component carrier (2) of any of the above claims, characterized in that the fan (8) is a radial fan.

17. An electronic device having the component carrier (2) of any of claims 1 to 16, characterized in that the component carrier (2) is disposed in a package (10) such that the air stream is guided in operation between one side of the component carrier (2) and the package wall and between the other side of the component carrier (2) and the package wall.

18. The electronic device of claim 17, characterized in that two component carriers (2) are provided with a joint fan (8) in a package (10), the sides with the components (2) or the sides with the air cooling bodies (6) being disposed opposite each other and forming a flow channel for the air stream between each other.

## Revendications

1. Support de composants (2) avec des composants (4) électriques fixés à celui-ci, comportant au moins un canal (14) pour un liquide de refroidissement, caractérisé en ce que le support de composants (2) comporte un corps de refroidissement par air (6) et en ce qu'au support de composants (2) est associé un ventilateur (8) au moyen duquel un courant d'air de circulation peut être produit pour le refroidissement par air d'au moins une partie des composants (4) et pour le refroidissement par air de retour au corps de refroidissement par air (6).

2. Support de composants (2) selon la revendication 1, caractérisé en ce qu'il est composé d'au moins une plaque de support (12) avec les composants (4) et le corps de refroidissement par air (6).

3. Support de composants (2) selon la revendication 2, caractérisé en ce que la plaque de support (12) et le corps de refroidissement par air (6) sont assemblés entre eux à plat et enferment entre eux au moins un canal (14).

4. Support de composants (2) selon l'une des revendications 1 à 3, caractérisé en ce que le ou les canaux (14) est (sont) pourvu(s) d'un orifice d'entrée et d'un orifice de sortie de manière que les deux orifices se trouvent sur ou au droit d'un côté frontal du support de composants (2).

5. Support de composants (2) selon l'une des revendications 1 à 3, caractérisé en ce que le ou les canaux (14) est (sont) pourvu(s) d'un orifice d'entrée et d'un orifice de sortie de manière que les orifices se trouvent sur ou au droit de côtés frontaux opposés du support de composants (2).

6. Support de composants (2) selon l'une des revendications précédentes, caractérisé en ce que le corps de refroidissement par air (6) comporte des ailettes de refroidissement ou des lamelles de refroidissement (16).

7. Support de composants selon l'une des revendications précédentes, caractérisé en ce que le ventilateur (8) est disposé de manière que pour un bon fonctionnement le courant d'air produit par le fonctionnement du ventilateur (8) s'éloigne du ventilateur (8) sur un côté du support de composants (2) et mène au ventilateur (8), sur l'autre côté du support de composants (2).

8. Support de composants selon l'une des revendications précédentes, caractérisé en ce qu'il est prévu à l'intérieur au moins un orifice de traversée (18) à travers lequel une partie au moins du courant d'air peut s'écouler d'un côté à l'autre.

9. Support de composants (2) selon la revendication 8, caractérisé en ce qu'un orifice de traversée (18) du support de composants (2) est disposé dans un élément de construction (4) de manière que la partie du courant d'air qui le traverse peut refroidir cet élément de façon ciblée.

10. Support de composants (2) selon l'une des revendications précédentes, caractérisé en ce qu'un élément de guidage est prévu pour le guidage ciblé d'une partie du courant d'air.

11. Support de composants (2) selon la revendication 10, caractérisé en ce qu'un élément de guidage est prévu pour le guidage ciblé d'une partie du courant d'air vers un élément de construction (4).

12. Support de composants (2) selon la revendication 10 ou 11, caractérisé en ce qu'un élément de guidage de type buse est associé à un orifice de traversée (18).

13. Support de composants (2) selon la revendication 12, caractérisé en ce qu'il est prévu un élément de guidage du type buse à emboîtement.

14. Support de composants (2) selon l'une des revendications précédentes, caractérisé en ce que le ventilateur (8) est disposé sur l'un des côtés frontaux du support de composants (2).

15. Support de composants (2) selon l'une des revendications précédentes, caractérisé en ce que le ventilateur (8) est un ventilateur à courant transversal.

16. Support de composants (2) selon l'une des revendications précédentes, caractérisé en ce que le ventilateur (8) est un ventilateur radial.

17. Appareil électronique comportant un support de composants (2) selon l'une des revendications 1 à 16, caractérisé en ce que le support de composants (2) est disposé dans un boîtier (10) de manière qu'en fonctionnement, le courant d'air soit guidé entre un côté du support de composants (2) et la paroi du boîtier et entre l'autre côté du support de composants (2) et la paroi du boîtier.

18. Appareil électronique selon la revendication 17, caractérisé en ce que sont prévus deux supports de composants (2) avec un ventilateur (8) commun dans un boîtier (10), les côtés présentant les composants (2) ou les côtés présentant les corps de refroidissement par air (6) étant disposés opposés l'un à l'autre et formant entre eux un canal d'écoulement pour le courant d'air.
